# FASCICULE DE BREVET EUROPEEN

(11) **EP 1 314 229 B1**
(45) Date de publication et mention de la délivrance du brevet: **02.03.2005**
(21) Numéro de dépôt: 01960039.4
(22) Date de dépôt: 28.08.2001
(51) Int. Cl.: H01S 5/30, H01S 5/34

(54) **LASER A CASCADES QUANTIQUES**
QUANTENKASKADIERTER LASER
QUANTUM CASCADE LASER

(30) Priorité: 31.08.2000 EP 00810783
(43) Date de publication de la demande: 28.05.2003
(73) Titulaire: Alpes Lasers S.A., 2000 Neuchâtel (CH)
(72) Inventeur: FAIST, Jérôme, CH-2000 Neuchâtel (CH); BECK, Mattias, CH-4054 Basel (CH); MULLER, Antoine, CH-2000 Neuchâtel (CH)
(74) Mandataire: Gresset, Jean
(86) Numéro de dépôt international: PCT/CH2001/000522
(87) Numéro de publication internationale: WO 2002/019485

(56) Documents cités:
- US-A- 5 457 709
- US-A- 5 570 386
- FAIST J. ET AL.: "A Quantum Cascade Laser Based on an n-i-p-i Superlattice" IEEE PHOTONICS TECHNOLOGY LETTERS, vol. 12, no. 3, mars 2000 (2000-03), pages 263-265, XP002158832
- FAIST J. ET AL.: "High-Power Continuous-Wave Quantum Cascade Lasers" IEEE JOURNAL OF QUANTUM ELECTRONICS, vol. 34, no. 2, février 1998 (1998-02), pages 336-343, XP002158833
- CAMPMAN KL ET AL: "Interface roughness and alloy-dissorder scattering contributions to intersubband transition linewidths" APPLIED PHYSICS LETTERS, vol. 69, no. 17, octobre 1996 (1996-10), pages 2554-2556, XP002158834 cité dans la demande

## Description

La présente invention se rapporte aux lasers à cascades quantiques. Elle concerne plus particulièrement les lasers comportant:
- une région de gain formée:
   - de plusieurs couches qui comprennent chacune une alternance de strates d'un premier type définissant chacune une barrière quantique et de strates d'un second type définissant chacune un puits quantique, lesdites strates étant constituées d'un premier et d'un second matériaux semi-conducteurs, respectivement constitutifs desdites barrières et desdits puits, et
   - de plusieurs barrières d'injection, chacune étant formée d'une strate du premier type et intercalée entre deux desdites couches,
- deux couches de confinement optique disposées de part et d'autre de la région de gain, et
- deux électrodes, chacune attenante à l'une des couches de confinement pour y appliquer un champ électrique.

Dans le présent document, on appelle "strate" une couche de faible épaisseur, présentant une certaine homogénéité dans sa composition, et "couche" un ensemble de strates assurant une même fonction.

Un laser de ce type est décrit dans le brevet US 5,457,709. Il est constitué de strates de premier et de second types, qui forment respectivement des barrières et des puits quantiques. Les matériaux constitutifs des barrières et des puits sont choisis de manière à ce qu'ils présentent une maille égale à celle du substrat, de façon à conserver la structure monocristalline dans toute l'épaisseur du laser.

La différence de potentiel cristallin des premier et second matériaux constituant respectivement les strates de premier et de second types définit, par effet de quantification, un ou plusieurs états bidimensionnels appelés sous-bandes.

Chacune des couches comporte une zone active et une zone de relaxation d'énergie. L'application d'un champ électrique aux bornes des électrodes engendre un courant de porteurs de charges à l'intérieur, notamment, de la région de gain.

L'émission d'un rayonnement laser est engendrée par la transition de porteurs de charges dans la zone active d'une première à une deuxième sous-bande. Ces porteurs de charge sont, en général, des électrons. Ce phénomène, appelé transition inter-sous-bandes, est accompagné de l'émission d'un photon.

Plus précisément, les puits de la zone active comportent, au moins, trois sous-bandes, appelées respectivement sous-bandes supérieure, médiane et inférieure. L'émission des photons se fait lors d'une transition entre les sous-bandes supérieure et médiane. Cette transition est rendue possible du fait que la population de la sous-bande médiane est réduite par transfert de ses électrons vers la sous-bande inférieure, avec émission d'un phonon optique. Pour qu'il puisse en être ainsi, il faut que l'énergie perdue par un porteur de charge passant de la sous-bande médiane à la sous-bande inférieure soit plus grande ou égale à celle des phonons optiques propre au matériau utilisé.

Dans le brevet mentionné plus haut, il est expliqué que la zone de relaxation d'énergie est agencée de manière à randomiser les porteurs de charges et dissiper leur énergie excédentaire pour permettre une injection efficace dans la couche suivante. Ainsi, la population de la sous-bande médiane est réduite, d'où une inversion de population entre les sous-bandes supérieure et médiane.

La barrière d'injection, qui est plus épaisse que les autres barrières, est intercalée entre deux couches adjacentes de la région de gain, pour assurer le passage des électrons de la sous-bande inférieure d'une couche vers la sous-bande supérieure de l'autre.

Un autre laser de ce type est décrit dans App. Phys. Letters, Volume 73, numéro 15 du 12 octobre 1998 et intitulé "High performance interminiband quantum cascade lasers with graded superlattices" (A. Tredicucci et al.). Ce laser est dit de type à extraction par minibandes. Dans ce cas, bien que le principe d'excitation diffère de celui évoqué plus haut, on trouve également une zone active, une zone de relaxation et une barrière d'injection.

En fait, pour qu'un monocristal de ce type puisse engendrer un rayonnement laser, il doit assurer trois fonctions:
- une inversion de population d'électrons entre les deux sous-bandes supérieure et médiane, dans chacune des couches, cette fonction étant assurée par la zone active,
- un refroidissement (ou une relaxation) des électrons, après transition, dans chacune des couches, cette fonction étant assurée par la zone de relaxation, et
- une injection des électrons d'une couche dans la suivante, cette fonction étant assurée par la barrière d'injection.

C'est en ajustant de manière adéquate le dopage et l'épaisseur des strates qu'il est possible de leur faire jouer les fonctions évoquées plus haut. Ce savoir-faire est parfaitement connu de l'homme du métier. Toutes les informations utiles, à ce propos, se trouvent dans le brevet mentionné plus haut.

Il est constaté que, dans les lasers connus, si la barrière d'injection est la plus épaisse des barrières de chaque couche, c'est, par contre, dans la zone active que les épaisseurs des barrières sont les plus faibles, allant croissantes de la barrière d'injection vers la zone de relaxation. Le passage de la zone active à la zone de relaxation est marqué par un doublement de l'épaisseur de la première barrière. Dans le mode de réalisation décrit par Tredicucci et al., l'épaisseur des barrières de la zone de relaxation continue à croître jusqu'à la barrière d'injection suivante.

Dans des lasers à extraction par phonon optique, tels que celui décrit dans le brevet mentionné plus haut et dans Appl. Phys. Letters, volume 75 numéro 11 du 13 septembre 1999 dans une publication intitulée "Electrically tunable, room-temperature quantum-cascade lasers" (A. Müller et al.), seule la barrière de la zone de relaxation adjacente à la zone active est beaucoup plus épaisse que les barrières de la zone active.

Les épaisseurs de ces strates sont telles que, dans les zones actives, des électrons sont présents dans les trois sous-bandes, alors que dans les zones de relaxation, les électrons sont confinés dans la sous-bande inférieure.

Lorsque les électrons ont transité vers la sous-bande inférieure d'une couche, Ils migrent, au travers de la zone de relaxation et de la barrière d'injection, vers la couche voisine, dont la sous-bande supérieure correspond sensiblement au potentiel de la sous-bande inférieure d'où proviennent les électrons.

La variation de l'épaisseur des barrières lors du passage de la zone active à la zone de relaxation permet de confiner, dans la zone active, les électrons présents dans la couche supérieure.

En complément à la littérature mentionnée plus haut, on relèvera une étude complète relative aux lasers à cascades quantiques, présentée dans l'ouvrage intitulé "Semi-conductors and semi-metals" Vol. 66", au chapitre 1 "Quantum Cascade Lasers" Academic Press, 2000.

Le but essentiel de la présente invention est de réaliser un laser basé sur un principe différent de ceux mentionnés plus haut, et qui présente des caractéristiques comparables, voire supérieures aux lasers connus. Ce but est atteint grâce au fait que les couches de la région de gain constituent chacune une zone active s'étendant de l'une à l'autre des barrières d'injection qui lui sont adjacentes chacune desdites barrières d'injection s'étendant de l'une à l'autre des zones actives qui lui sont adjacentes, et dans laquelle lesdites strates sont dimensionnées de manière à ce que:
- chacun des puits comporte, en présence d'un champ électrique, au moins une première sous-bande, supérieure, une deuxième sous-bande, médiane, et une troisième sous-bande, inférieure,
- la probabilité de présence d'un électron:
   - dans la première sous-bande, soit la plus élevée au voisinage de l'une des barrières adjacentes,
   - dans la deuxième sous-bande, soit la plus élevée dans la partie médiane de la zone active, et
   - dans la troisième sous-bande, soit la plus élevée au voisinage de l'autre des barrières adjacentes, et
- la transition d'un électron de la sous-bande supérieure à la sous-bande médiane est à l'origine du gain optique.

Il est, en effet, apparu que, contrairement à ce que considérait l'homme du métier, il n'est pas nécessaire que les couches comportent une zone active, et une zone de relaxation.

La pratique a, en effet, montré qu'il était tout à fait possible de faire fonctionner des lasers formés d'une succession de zones actives et de barrières d'injections, sans interposition d'une zone de relaxation.

De manière avantageuse, l'épaisseur des strates de premier type de la zone active est monotone croissante de l'une à l'autre des barrières adjacentes.

Par ailleurs, dans de tels lasers, les premier et second matériaux, respectivement constitutifs des barrières et des puits, sont déposés successivement, en veillant à ce que ceux-ci soient purs ou dopés de manière adéquate, chaque strate présentant une composition homogène, à l'exception des quelques couches atomiques attenantes aux strates voisines. En procédant ainsi, on obtient une succession de puits et de barrières présentant des flancs quasiment verticaux. Or, il a été constaté qu'aux interfaces de ces strates, les électrons avaient tendances à diffuser.

Plus précisément, l'étude faite par K. L. Campman et al., et publiée sous le titre "Interface roughness and alloy-disorder scattering contributions to intersubband transition linewidths" dans Appl. Phys. Letters 69 (17), 21 octobre 1996, a montré que les interfaces des strates ont une influence déterminante sur l'élargissement de la transition inter-sous-bandes, ce qui engendre une augmentation du courant de seuil.

Afin de pallier cet inconvénient, et dans un mode de réalisation particulièrement intéressant, les strates de premier et de second types présentent respectivement des concentrations de 100% des premier et de second matériaux dans leur parties médianes, alors qu'entre deux parties médianes, les strates sont formées d'un alliage desdits deux matériaux dont la concentration varie de manière continue.

La pratique a montré qu'il était particulièrement intéressant que le laser comporte un substrat, en phosphure d'indium (InP), sur lequel les différentes couches sont disposées.

Selon les applications, la longueur d'onde du rayonnement laser doit être plus ou moins courte. Une étude effectuée par J. Faist et al., intitulée "Short wavelength quantum cascade laser based on strained compensated InGaAs/AIInAs" et publiée dans Appl. Phys. Letters Vol. 72, No 6 du 9 février 1998, a montré qu'il est possible d'augmenter la différence de potentiel cristallin des deux matériaux constituant les strates et, en conséquence réduire la longueur d'onde des photons émis. C'est pourquoi, de manière avantageuse, les premier et second matériaux sont choisis de telle sorte qu'ils présentent des mailles l'un plus grandes, l'autre plus petites que celles du substrat.

Dans certaines applications, il est nécessaire de disposer d'un rayonnement présentant un spectre étroit d'émission. A cet effet, la couche de confinement opposée au substrat présente une structure définissant un réseau de diffraction de pas égal à un multiple de la moitié d'une longueur d'onde désirée de son spectre d'émission.

Avec un substrat en InP, il est avantageux que le second matériau soit de l'InGaAs et le premier soit choisi parmi l'AIGaAs, l'InP et l'AllnAs.

D'autres avantages et caractéristiques de l'invention ressortiront de la description qui va suivre, faite en regard du dessin annexé, dans lequel:
- La figure 1 montre, de manière schématique et vu en coupe, un laser selon l'invention,
- La figure 2 représente des courbes montrant la variation de l'épaisseur des strates, en a, b et c pour des lasers de types connus, et en d pour un laser selon l'invention,
- La figure 3 donne, sous forme de courbes, des caractéristiques physiques obtenues au moyen d'un laser selon l'invention, et
- La figure 4 montre la variation de la composition chimique des strates dans une couche de la région de gain.

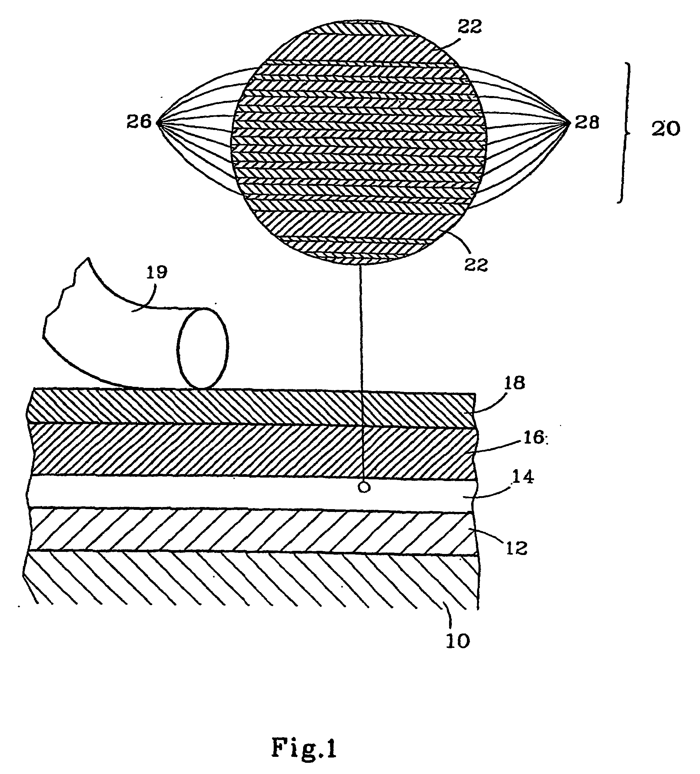

La figure 1 représente, schématiquement et à titre d'exemple, une coupe d'un laser à cascades quantiques selon l'invention, de type unipolaire et dans lequel les électrons sont les porteurs de charge.

Sur cette figure, les échelles relatives ne peuvent pas être respectées, à causes des épaisseurs particulièrement faibles de certaines couches. Le laser comporte un substrat 10 en phosphure d'indium (InP) monocristallin, tenant lieu d'électrode. Sur ce substrat 10, sont empilés une première couche de confinement optique 12, une région de gain 14, formée d'une structure stratifiée, une seconde couche de confinement optique 16, et une électrode 18. Le substrat 10 est fixé sur un support non représenté au dessin. Un fil 19 est fixé sur l'électrode 18. L'alimentation du laser se fait en appliquant une tension entre le support et le fil 19.

Les couches de confinement optique 12 et 16 sont formées d'un alliage d'arséniure d'indium et de gallium (InGaAs), à raison de 52% d'arséniure d'indium et 48% d'arséniure de gallium. Une telle composition permet de définir une structure cristalline, de même maille et identique à celle de l'InP.

Ainsi qu'on peut le voir sur la partie agrandie de la figure 1, la région de gain 14 est constituée de couches successives 20, et de barrières d'injection 22.

Les couches 20 sont formées de strates 26 d'un premier type et de strates 28 d'un second type, disposées en alternance. Les barrières d'injection 22 sont constituées d'une seule strate, alors que les couches 20 comportent au moins trois strates 28 de second type, typiquement de cinq à vingt-cinq.

Chacune des strates 26, qui forme une barrière quantique, est essentiellement constituée d'un alliage d'AllnAs, à raison de 53% molaire d'arséniure d'indium et 47% d'arséniure d'aluminium. Une telle composition engendre une structure cristalline identique à celle de l'InP.

Chacune des strates 28, qui forme un puits quantique, est essentiellement constituée d'un alliage d'inGaAs de même composition que les couches de confinement optique 12 et 16.

Un laser selon l'invention a été réalisé selon la structure exposée dans le tableau 1 ci-dessous.

**Tableau 1**

| **Référence** | **Matériau** | **Dopant** | **Niveau de dopage [cm**^{**-3**}**]** | **Epaisseur [nm]** |
|---|---|---|---|---|
| Substrat 10 | InP | Si | 1-5x10¹⁷ | massif |
| Couche confinement optique 12 | Ga_{0.5x} Al_{0.5(1-x)} InAs | | 2x10¹⁷ | 25 |
| | InGaAs | | 6x10¹⁸ | 200 |
| | Ga_{0.5x}Al_{0.5(1-x)} InAs | | 3X10¹⁷ | 12,4 |
| Région de gain 14 | 35 fois la structure du tableau 2 | | | 2128 |
| Couche de confinement optique 16 | Ga_{0.5x} Al_{0.5(1-x)} InAs | | 3X10¹⁷ | 23 |
| | InGaAs | | 6x10¹⁸ | 200 |
| | Ga_{0.5x} Al_{0.5(1-x)} InAs | | 2x10¹⁷ | 30 |
| Electrode 18 | InP | | 1x10¹⁷ | 2500 |
| | InP | | 7x10¹⁸ | 850 |
| | InP | | 1x10²⁰ | 10 |

Des exemples des caractéristiques des couches de confinement optique 12 et 16 et de l'électrode 18 sont donnés de manière complète dans les demandes de brevets déposées sous les numéros PCT/CH 99/00572 et PCT/CH 00/00159 au nom de la demanderesse. C'est pourquoi, leurs structures ne seront pas précisées de manière plus détaillée.

Le tableau 2 donne la composition des strates formant une barrière d'injection 22 et une couche 20 de la région de gain 14, qui en comporte trente-cinq.

**Tableau 2**

| **Référence** | **Matériau** | **Dopant** | **Niveau de dopage [cm**^{**-3**}**]** | **Epaisseur [nm]** |
|---|---|---|---|---|
| Barrière d'injection 22 | AllnAs | | | 4,0 |
| Couche 20 | InGaAs | | | 2,0 |
| | AllnAs | | | 0,7 |
| | InGaAs | | | 6,0 |
| | AIInAs | | | 0,9 |
| | InGaAs | | | 5,9 |
| | AIInAs | | | 1,0 |
| | InGaAs | | | 5,2 |
| | AIInAs | | | 1,3 |
| | InGaAs | | | 3,8 |
| | AIInAs | | | 1,4 |
| | InGaAs | | | 3,5 |
| | AIInAs | | | 1,5 |
| | InGaAs | Si | 3.10¹⁷ | 3,3 |
| | AIInAs | Si | 3.10¹⁷ | 1,6 |
| | InGaAs | Si | 3.10¹⁷ | 3,1 |
| | AIInAs | Si | 3.10¹⁷ | 1,9 |
| | InGaAs | | | 3,1 |
| | AllnAs | | | 2,3 |
| | InGaAs | | | 3,0 |
| | AIInAs | | | 2,4 |
| | InGaAs | | | 2,9 |

La couche 20 est formée de dix strates de premier type et onze de second type, alors que la barrière 22 est constituée d'une seule strate de premier type.

Les strates des couches 20 sont dimensionnées de manière à ce que chacun des puits de la couche comporte au moins une sous-bande supérieure, une sous-bande médiane et une sous-bande inférieure, les sous-bandes de même type étant sensiblement au même potentiel lorsque le laser est alimenté. De manière classique, la transition d'un électron de la sous-bande supérieure à la sous-bande médiane est à l'origine du gain optique.

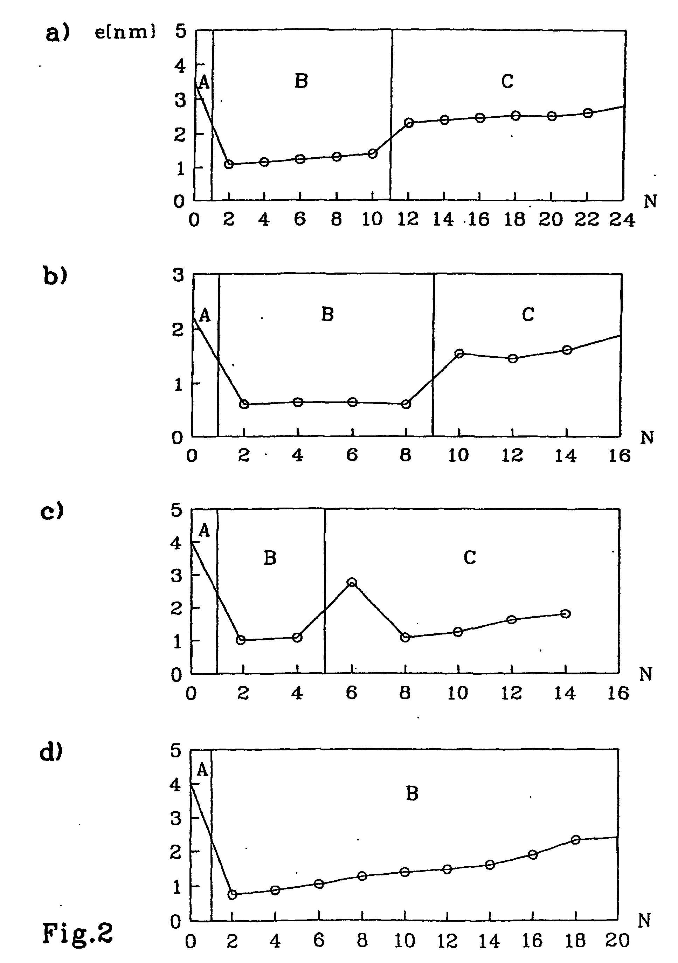

La figure 2 permet de voir de manière particulièrement claire en quoi la structure du laser selon l'invention diffère de celles appliquées jusqu'ici dans les lasers à cascades quantiques. Elle comporte quatre diagrammes, dont trois a, b et c se rapportent à des lasers connus, alors que le diagramme d correspond à un laser selon l'invention. L'abscisse N indique le rang des strates de la couche 20 alors que l'ordonnée donne l'épaisseur e de la strate considérée, exprimée en nm. Seules les épaisseurs des strates de rang pair, qui se rapportent aux barrières, ont été indiquées, les informations concernant les puits n'étant pas significatives. La strate de rang zéro se rapporte à la barrière d'injection 22.

Plus précisément, les diagrammes a, b et c correspondent respectivement à des lasers décrits dans les documents suivants:
- "High performance interminiband quantum cascade laser with graded superlattice", de A. Tredicucci et al. dans Appl. Phys. Letters, volume 73 No 15, du 12 octobre 1998;
- "Long wavelength superlattice quantum cascade lasers at λ=17 µm", de Tredicucci et al. dans Appl. Phys. Letters, volume 74 No 5, du 1er février 1999 et
- "Electrically tunable, room-temperature quantum-cascade lasers" de A. Müller et al. dans Appl. Phys. Letters, volume 75 numéro 11 du 13 septembre 1999.

On reconnaît, sur ces trois diagrammes, trois parties distinctes. La partie A, qui correspond à la barrière d'injection, présente une épaisseur importante. La partie B, dans laquelle les épaisseurs sont faibles et vont croissantes à partir de la partie A, concerne la zone active. La partie C se rapporte à la zone de relaxation. Le diagramme d ne montre, par contre que deux parties distinctes A et B, correspondant respectivement à la barrière d'injection et à la zone active.

Plus précisément, on constate que, dans les diagrammes a et b, les strates formant les barrières de la zone de relaxation ont sensiblement une épaisseur égale au double de celles des strates de la zone active alors que, dans le diagramme c, seule une strate de la zone de relaxation, située à l'interface avec la zone active, est sensiblement plus épaisse. Cette variation d'épaisseur entre zone active et zone de relaxation permet de confiner les électrons dans la zone active, ce que l'homme du métier considérait, jusqu'ici, comme indispensable.

Au contraire, le diagramme d montre une augmentation monotone croissante de l'épaisseur des strates de premier type, d'une barrière d'injection à la suivante.

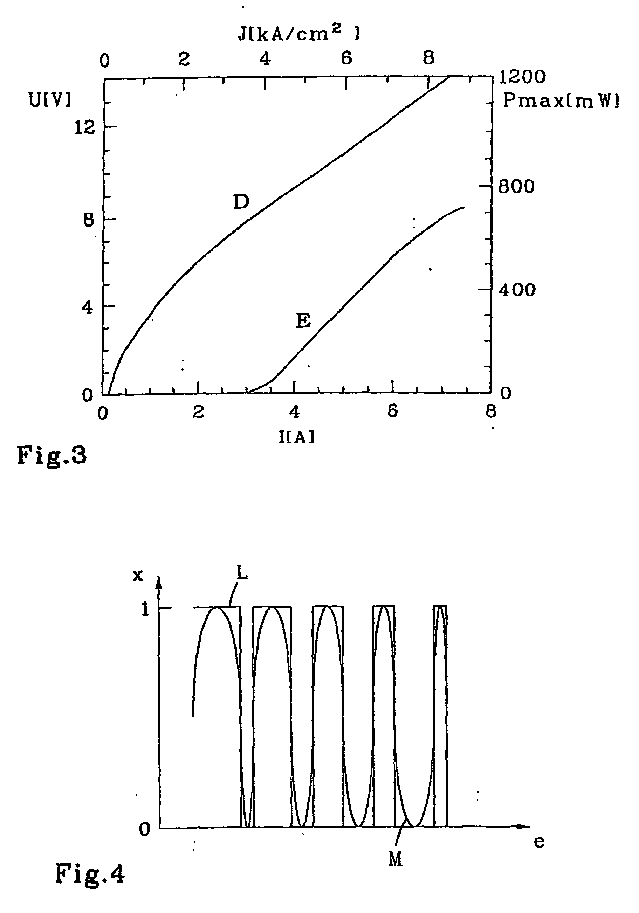

Les essais effectués montrent qu'il est possible de faire fonctionner un laser sans pour autant qu'il ait une zone de relaxation. Le diagramme de la figure 3 présente les caractéristiques obtenues avec un prototype réalisé selon la structure spécifiée plus haut. La courbe D montre la relation entre la tension U, exprimée en volts et la densité de courant J, exprimée en kA/cm². La courbe E se rapporte à la relation entre la puissance maximale Pₘₐₓ, exprimée en mW et le courant I exprimé en ampères.

Le tableau 3 ci-après permet de comparer ces résultats avec ceux obtenus par le laser du diagramme 2a, à 30°C, soit dans des conditions de fonctionnement à la température ambiante.

**Tableau 3**

| **Caractéristiques à 30°C** | **Invention** | **Etat de la technique** |
|---|---|---|
| Puissance maximale | 700 mW (I = 7 A) | 500 mW (I = 11 A) |
| Courant de seuil | 3,2 A | 4, 5 A |
| Densité de courant de seuil | 4,0 kA/cm² | 5,2 kA/cm² |
| Efficacité | 250 mW/A | 120 mW/A |

Les résultats obtenus avec d'autres températures sont tout à fait comparables. Il apparaît ainsi clairement que le laser selon l'invention permet, sans autre, de rivaliser avec les lasers connus, leurs performances étant même supérieures.

Le laser selon l'invention peut être amélioré en modifiant la composition chimique des strates dans la région de gain, comme le montre la figure 4. Sur cette figure, il est considéré que la composition chimique répond à la formule Gaₓ Al_{{l-x}} InAs, dans laquelle x varie de 0 à 1, selon la position considérée dans l'épaisseur de la couche. L'abscisse se rapporte à l'épaisseur e de la structure et l'ordonnée à x. La courbe L montre la variation de la composition telle qu'elle se présente dans les lasers selon l'état de la technique ainsi que dans l'exemple donné plus haut, alors que la courbe M se rapporte à un mode particulier de réalisation.

Pour réaliser une structure ayant une composition correspondant à la courbe L, les matériaux (InGaAs et AllnAs) sont déposés successivement. En procédant ainsi, les puits et les barrières forment des flancs quasiment verticaux, la diffusion entre strates étant faible. Il a été constaté qu'aux interfaces de ces strates, les électrons avaient tendance à diffuser, comme expliqué par K. L. Campman et al, dans son article cité plus haut.

Une composition de la couche telle que correspondant à la courbe M permet de pallier cet inconvénient. Cette courbe présente une forme avec des maxima dans les parties médianes des strates, la composition variant de manière continue entre deux parties médianes.

Il est, notamment, possible de réaliser une couche telle que celle représentée par la courbe M en alternant de manière plus fréquente les dépôts de InGaAs et AIInAs, l'épaisseur de chaque dépôt représentant une portion de strate, correspondant à quelques couches atomiques.

Dans certaines applications, il est nécessaire de disposer d'un spectre étroit d'émission de la lumière. Cette condition peut être satisfaite avec une couche de confinement supérieure, c'est-à-dire disposée du côté opposé au substrat, qui présente une structure définissant un réseau de diffraction de pas égal à un multiple de la longueur d'onde désirée de son spectre d'émission. L'obtention d'un tel réseau est décrite dans la demande de brevet déposée sous le numéro PCT/CH 0010159, sous le titre "Laser semi-conducteur infrarouge", au nom de la demanderesse.

Le laser à cascades quantiques selon l'invention peut faire l'objet de nombreuses variantes, sans pour autant sortir du cadre de l'invention. D'autres matériaux que le AllnAs peuvent constituer les barrières, par exemple l'InP ou l'AlGaAs. Le nombre des strates et leurs épaisseurs peuvent aussi considérablement varier.

## Revendications

1. Laser à cascades quantiques comportant:
• une région de gain (14) formée:
- de plusieurs couches (20) qui comprennent chacune une alternance de strates d'un premier type (26) définissant chacune une barrière quantique et de strates d'un second type (28) définissant chacune un puits quantique, lesdites strates étant constituées d'un premier et d'un second matériaux semi-conducteurs, respectivement constitutifs desdites barrières et desdits puits, et
- de plusieurs barrières d'injection (22), chacune étant formée d'une strate du premier type et intercalée entre deux desdites couches (20).
• deux couches de confinement optique (12,16) disposées de part et d'autre de la région de gain (14), et
• deux électrodes (18), chacune attenante à l'une des couches de confinement (12, 16) pour y appliquer un champ électrique,
**caractérisé en ce que** les couches (20) de la région de gain (14) constituent chacune une zone active s'étendant de l'une à l'autre des barrières d'injection (22) qui lui sont adjacentes chacune desdites barrières d'injection s'étendant de l'une à l'autre des zones actives qui lui sont adjacentes et dans laquelle lesdites strates (26, 28) sont dimensionnées de manière à ce que:
• chacun des puits (28) comporte, en présence d'un champ électrique, au moins une première sous-bande, supérieure, une deuxième sous-bande, médiane, et une troisième sous-bande, inférieure,
• la probabilité de présence d'un électron:
- dans la première sous-bande, soit la plus élevée au voisinage de l'une des barrières d'injection adjacentes,
- dans la deuxième sous-bande, soit la plus élevée dans la partie médiane de la zone active, et
- dans la troisième sous-bande, soit la plus élevée au voisinage de l'autre des barrières d'injections adjacentes, et
• la transition d'un électron de la sous-bande supérieure à la sous-bande médiane soit à l'origine du gain optique.

2. Laser selon la revendication 1, **caractérisé en ce que**, dans chaque couche (20) de la région de gain, l'épaisseur des strates de premier type (26) de la zone active est monotone croissante de l'une à l'autre des barrières adjacentes (22).

3. Laser selon l'une des revendications 1 et 2, **caractérisé en ce que** les strates de premier (26) et de deuxième types (28) présentent respectivement des concentrations de 100% des premier et de second matériaux dans leur parties médianes, alors qu'entre deux parties médianes, les strates sont formées d'un alliage desdits deux matériaux, dont les concentrations varient de manière continue.

4. Laser selon l'une des revendications 1 à 3, **caractérisé en ce qu'**il comporte, en outre, un substrat (10) en InP, sur lequel sont disposées lesdites couches.

5. Laser selon l'une des revendications 1 à 4, **caractérisé en ce que** lesdits premier et second matériaux sont choisis de manière à ce qu'ils présentent des mailles l'un plus grandes, l'autre plus petites que celles dudit substrat (10).

6. Laser selon l'une des revendications 4 et 5, **caractérisé en ce que** la couche de confinement opposée audit substrat (10) présente une structure définissant un réseau de diffraction de pas égal à un multiple de la moitié d'une longueur d'onde désirée de son spectre d'émission.

7. Laser selon l'une des revendications 4 et 6, **caractérisé en ce que** le second matériau est de l'InGaAs et le premier est choisi parmi l'AlGaAs, l'InP et l'AllnAs.

## Claims

1. A quantum cascade laser comprising:
• a gain region (14) formed:
- from several layers (20) each including alternating strata of a first type (26) each defining a quantum barrier and strata of a second type (28) each defining a quantum well, said strata consisting of a first and of a second semiconductor material, respectively constituting said barriers and said wells, and
- from several injection barriers (22), each one being formed from a stratum of the first type and interposed between two of said layers (20),
• two optical confinement layers (12, 16) placed on each side of the gain region (14), and
• two electrodes (18), each one adjoining one of the confinement layers (12, 16) in order to apply an electric field thereto,
**characterized in that** the layers (20) of the gain region (14) each constitute an active region extending from one of the injection barriers (22) to the other which are adjacent thereto, each of said interposed injection barriers extending from one of the active regions to the other which are adjacent thereto, and in which said strata (26, 28) are dimensioned such that:
• said wells (28) comprise, in the presence of an electric field, at least a first upper sub-band, a second middle sub-band and a third lower sub-band,
• the probability of an electron being present:
- in the first sub-band, is highest in the vicinity of one of the adjacent injection barriers,
- in the second sub-band, is highest in the middle part of the active region, and
- in the third sub-band, is highest in the vicinity of the other of the adjacent injection barriers, and
• the transition of an electron from the upper sub-band to the middle sub-band forms the basis for the optical gain.

2. Laser according to Claim 1, **characterized in that**, in each layer (20) of the gain region, the thickness of the first type of strata (26) of the active region increases monotonically from one of the adjacent barriers (22) to the other.

3. Laser according to either of Claims 1 and 2, **characterized in that** the first type of strata (26) and the second type of strata (28) have concentrations of 100% of the first and of the second materials, respectively, in their middle parts, while between two middle parts, the strata are formed from an alloy of said two materials, the concentrations of which vary continuously.

4. Laser according to one of Claims 1 to 3, **characterized in that** it further comprises an InP substrate (10), on which said layers are placed.

5. Laser according to one of Claims 1 to 4, **characterized in that** said first and second materials are chosen such that they have lattice parameters one of which is greater, the other of which is smaller than those of said substrate (10).

6. Laser according to either of Claims 4 and 5, **characterized in that** the confinement layer opposite said substrate (10) has a structure defining a diffraction grating having a pitch equal to a multiple of half the desired wavelength of its emission spectrum.

7. Laser according to either of Claims 4 and 6, **characterized in that** the second material is InGaAs and the first is chosen from AlGaAs, InP and AlInAs.

## Patentansprüche

1. Quantenkaskadenlaser mit:
• einem Verstärkungsbereich (14), gebildet aus:
- mehreren Schichten (20), die je eine abwechselnde Anordnung von Lagen eines ersten Typs (26), die je eine Quantenbarriere definieren, und Lagen eines zweiten Typs (28) aufweisen, die je einen Quantenbrunnen definieren, wobei die Lagen aus einem ersten und einem zweiten Halbleitermaterial bestehen, die die Barrieren bzw. die Brunnen bilden, und
- mehreren Injektionsbarrieren (22), die je aus einer Lage des ersten Typs gebildet und zwischen zwei der Schichten (20) eingeschoben sind,
• zwei optischen Isolierschichten (12, 16), die zu beiden Seiten des Verstärkungsbereichs (14) angeordnet sind, und
• zwei Elektroden (18), die je an eine der Isolierschichten (12, 16) angrenzen, um an diese ein elektrisches Feld anzulegen,
**dadurch gekennzeichnet, dass** die Schichten (20) des Verstärkungsbereichs (14) je eine aktive Zone bilden, die sich von einer der ihnen benachbarten Injektionsbarrieren (22) zur anderen erstrecken, wobei jede der Einschub-Injektionsbarrieren sich von einer der ihr benachbarten aktiven Zonen zur anderen erstreckt, und in der die Lagen (26, 28) so bemessen sind, dass:
• die Brunnen (28) in Gegenwart eines elektrischen Felds mindestens ein erstes oberes Unterband, ein zweites mittleres Unterband und ein drittes unteres Unterband aufweisen,
• die Wahrscheinlichkeit des Vorhandenseins eines Elektrons:
- im ersten Unterband in der Nähe einer der benachbarten Injektionsbarrieren am höchsten ist,
- im zweiten Unterband im mittleren Bereich der aktiven Zone am höchsten ist, und
- im dritten Unterband in der Nähe der anderen der benachbarten Injektionsbarrieren am höchsten ist, und
• der Übergang eines Elektrons vom oberen Unterband zum mittleren Unterband der Ursprung der optischen Verstärkung ist.

2. Laser nach Anspruch 1, **dadurch gekennzeichnet, dass** in jeder Schicht (20) des Verstärkungsbereichs die Dicke der Lagen des ersten Typs (26) der aktiven Zone von einer der benachbarten Barrieren (22) zur anderen monoton ansteigend ist.

3. Laser nach einem der Ansprüche 1 und 2, **dadurch gekennzeichnet, dass** die Lagen des ersten (26) und des zweiten Typs (28) in ihren mittleren Bereichen 100 %-ige Konzentrationen des ersten bzw. zweiten Materials aufweisen, während zwischen zwei Mittelbereichen die Lagen aus einer Legierung der beiden Materialien gebildet werden, deren Konzentrationen kontinuierlich variieren.

4. Laser nach einem der Ansprüche 1 bis 3, **dadurch gekennzeichnet, dass** er außerdem ein Substrat (10) aus InP aufweist, auf das die Schichten aufgebracht sind.

5. Laser nach einem der Ansprüche 1 bis 4, **dadurch gekennzeichnet, dass** das erste und das zweite Material so gewählt werden, dass das eine größere und das andere kleinere Maschen aufweist als das Substrat (10).

6. Laser nach einem der Ansprüche 4 und 5, **dadurch gekennzeichnet, dass** die dem Substrat (10) gegenüberliegende Isolierschicht eine Struktur aufweist, die ein Beugungsgitter mit einem Gitterabstand gleich einem Vielfachen der Hälfte einer gewünschten Wellenlänge seines Sendespektrums definiert.

7. Laser nach einem der Ansprüche 4 und 6, **dadurch gekennzeichnet, dass** das zweite Material InGaAs ist, und das erste Material aus AlGaAs, InP und AlInAs ausgewählt wird.
